# EUROPEAN PATENT APPLICATION

(11) **EP 4 819 169 A1**
(43) Date of publication of application: **07.10.2026**
(21) Application number: 26164728.3
(22) Date of filing: 13.03.2026
(51) Int. Cl.: H01B 7/42, G06F 1/20, H01B 9/00

(54) **A FLUID COOLING SYSTEM FOR A FLUID COOLED SERVER SYSTEM**

(30) Priority: 01.04.2025 IT 202500006939
(71) Applicant: Prysmian S.p.A., 20126 Milan (IT)
(72) Inventor: DE RAI, Luca Giorgio Maria, 20126 Milano (MI) (IT)
(74) Representative: Praxi Intellectual Property Milano

(57) **Abstract**

The present disclosure relates to a fluid cooling system (1) for a fluid cooled server system (100), comprising:
- a fluid cooler device (2);
- a power cable (3) configured for providing electric power to the server system (100), the power cable (3) containing at least one inner supply conduit (4) for conveying a cooling fluid from the fluid cooler device (2) to the server system (100); and
- a return conduit (5) for conveying the heated cooling fluid from the server system (100) to the fluid cooler device (2),
wherein the return conduit (5) is physically distinct and separated from the power cable (3).

## Description

### BACKGROUND

### Technical field

The present disclosure relates to the field of cooling server systems, such as network servers and data centres.

### Description of the Related Art

With the development of high-performance data centres and cloud computing, network servers face the problem of heat dissipation. It is critical to keep the server cool while it is running. Excessive temperatures can cause it to crash and, in severe cases, result in data loss and service interruption. There is a temperature threshold that starts to affect server network performance. At this point, the computer connected to the server will also have some problems affecting the operating system. If the temperature continues to rise to a certain level, it will cause serious problems, such as fire, power outage, etc.

One of the server cooling technologies is the liquid cooling loop which can comprise a tube circuit where a fluid runs to and from the system to be cooled.

To the aim of reducing the dimensions of the cooling and of the server system, power cables transporting energy to the system have been provided with internal conduits to transport the cooling fluid to the system and back to the fluid cooler device. However, as the heated fluid coming from the system runs side by side the cooling fluid, the cooling capacity of the latter could be reduced.

For example, EP 4030688 A1 discloses an apparatus comprising a connector for connecting the apparatus to a cable delivering power, data, and cooling to the apparatus, the connector comprising an optical interface for receiving optical communications signals, an electrical interface for receiving power for powering the apparatus, and a fluid interface for receiving coolant. The apparatus further comprises a cooling loop for cooling electrical components of the apparatus with the coolant. A cable system provides high power energy delivery, fiber delivered data, and cooling within a single cable. The cable includes two coolant tubes (supply and return). The closed coolant loop is established through the two coolant tubes.

Another example of a cable incorporating a coolant tube is given in US 2023/154651 A1, which describes a covered wire including a tubular member through which a coolant flows; a conductor provided on an outer circumference of the tubular member; and a covering member covering an outer circumference of the conductor. The flow-through of the coolant is achieved by a circulation device including a first mechanism, a second mechanism, and a supply mechanism. The first mechanism is a connection mechanism for guiding the coolant from the outside of the covered wire into the tubular member. The second mechanism is a connection mechanism for discharging the coolant in the tubular member to the outside of the covered wire. The second mechanism includes a second coolant pipe. The coolant that has been heated in the process of flowing through the tubular member flows through the second coolant pipe. The object of the disclosure is to provide a covered wire that allows a conductor to be effectively cooled.

### SUMMARY OF THE INVENTION

The Applicant therefore aims at providing a fluid cooling system capable of efficiently cooling a server system while maintaining overall reduced dimensions of both the systems.

The Applicant has found that a fluid cooling system comprising a fluid cooler device, a power cable containing an inner supply conduit for transporting a cooling fluid from the fluid cooler device to a server system, and a return conduit for transporting a heated fluid from the server system to the fluid cooler device, wherein the power cable and the return conduit are physically separated one from the other, is capable of efficiently cooling the server system because the heated fluid coming from the server system does not exchange heat with the cooling fluid in the cable supply conduit, and keeps reduced dimensions.

Accordingly, the present disclosure relates to a fluid cooling system for a fluid cooled server system, the fluid cooling system comprising:
- a fluid cooler device;
- a power cable configured for providing electric power to the server system, the power cable containing at least one inner supply conduit for conveying a cooling fluid from the fluid cooler device to the server system; and
- a return conduit for conveying the heated cooling fluid from the server system to the fluid cooler device,
wherein the return conduit is physically distinct and separated from the power cable.

In an embodiment, the cooling fluid of the present fluid cooling system may be selected from deionized water, ethylene glycol, a mixture of water and ethylene glycol, an optionally dielectric fluid such as a mineral oil, engineered fluids.

In an embodiment, the present fluid cooling system further comprises a connector for connecting the power cable to the server system both electrically and fluidically.

In an embodiment, the present fluid cooling system further comprises a connector for connecting the power cable to the server system electrically, wherein the power cable inner supply conduit exits the power cable at a location different from the connector.

In an embodiment, the power cable of the present system comprises a data transmission unit for providing data to the server system.

In an embodiment, in the power cable of the present system each inner supply conduit is radially surrounded by an electrical conductor. In an alternative embodiment, the electrical conductor may be arranged within the respective inner supply conduit.

The present disclosure further relates to server system connected to the present fluid cooling system.

In an embodiment, the present server system and fluid cooler device are arranged in distinct and thermally insulated locations.

The preceding summary is to provide an understanding of some aspects of the disclosure. As will be appreciated, other embodiments of the disclosure are possible utilizing, alone or in combination, one or more of the features set forth above or described in detail below.

### BRIEF DESCRIPTION OF THE DRAWINGS

Further characteristics and advantages will be more apparent from the following description of some embodiments given as a way of an example with reference to the enclosed drawings in which:
Figure 1 schematically shows an embodiment of a fluid cooling system connected to a fluid cooled server system;
Figure 2 schematically shows another embodiment of the fluid cooling system connected to a fluid cooled server system;
Figure 3 schematically shows a power cable of the fluid cooling system according to an embodiment of the present disclosure in cross-section view;
Figure 4 schematically shows the power cable of the fluid cooling system according to another embodiment of the present disclosure in cross-section view.

### DETAILED DESCRIPTION

For the purpose of the present description and of the appended claims, except where otherwise indicated, all numbers expressing amounts, quantities, percentages, and so forth, are to be understood as being modified in all instances by the term "about". Also, all ranges include any combination of the maximum and minimum points disclosed and include any intermediate ranges therein, which may or may not be specifically enumerated herein.

For the purpose of the present description and of the appended claims, the words "a" or "an" are used to describe elements and components of the invention. This is done merely for convenience and to give a general sense of the invention. In this description and claims should be read to include one or at least one and the singular also includes the plural unless it is obvious that it is meant otherwise.

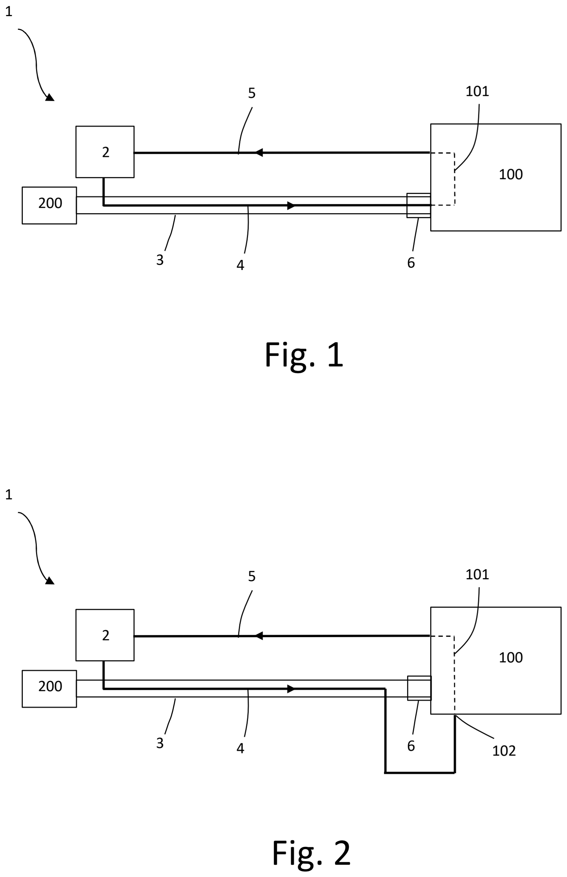

Figure 1 schematically shows a fluid cooling system 1 according to an embodiment of the present disclosure. The fluid cooling system 1 is here connected to a server system 100 with which the fluid cooling system 1 provides a cooling fluid.

The server system 100 can comprise e.g., a network server or a data centre including a server. The server system 100 may comprise, among other things, one or more CPUs, one or more GPUs, racks, memories, power supplies, hard drives, SSDs. This equipment generates heat necessitating to be cooled by the fluid cooling system 1. The absorbed power can be up to 800 kW, particularly in view of the continuously increasing use of Al, and the heat generated can be, accordingly, substantially up to 800 kJ/sec.

The fluid cooling system 1 comprises a fluid cooler device 2 providing a (cold) cooling fluid for the cooling of the server system 100. Non-limiting examples of cooling fluids are deionized water, ethylene glycol, a mixture of water and ethylene glycol, an optionally dielectric fluid such as a mineral oil, engineered fluids. Depending on the nature of the cooling fluid, the fluid cooler device 2 can be configured accordingly, in a manner known as such. For example, in the case the cooling fluid is water, the fluid cooler device 2 can comprise a chiller.

When the fluid cooling system 1 and the server system 100 are connected, they are thermally insulated one another (apart from the cooling fluid flowing and exchanging heat between them). In an embodiment, the server system 100 and the fluid cooler device 2 are to be arranged in distinct and thermally insulated locations, such as two distinct and thermally insulated rooms.

The fluid cooling system 1 comprises at least one power cable 3 configured for providing electric power and, optionally, data to the server system 100. To this purpose, the power cable 3 can be connected to a power source 200. Further details on the power cable 3 structure will be given below.

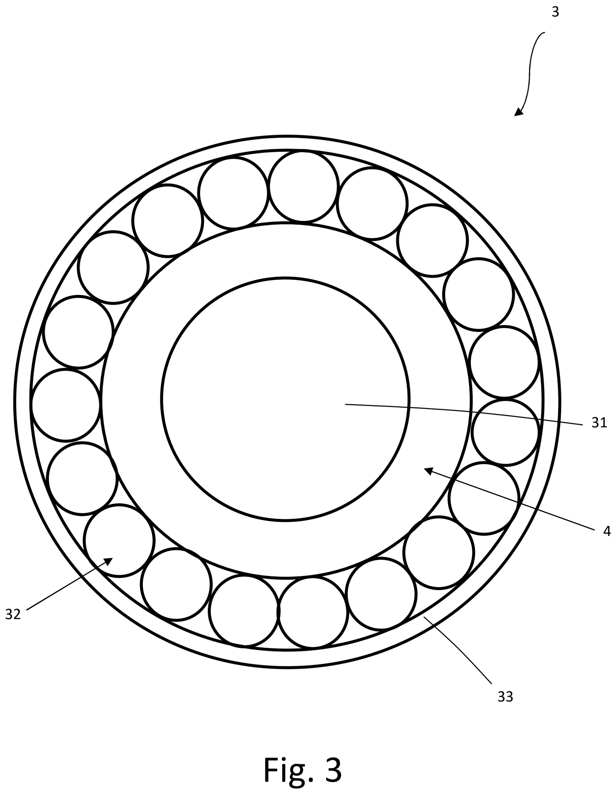

As from Figure 3, the power cable 3 contains at least one inner supply conduit 4 for conveying the cooling fluid from the fluid cooler device 2 to the server system 100. The cooling fluid flowing in the inner supply conduit 4 cools the conductors of the power cable 3 and then, flowing in the server system 100, cools the equipment thereof.

The fluid cooling system 1 further comprises a return conduit 5 connectable to the server system 100 and to the fluid cooler device 2. The return conduit 5 receives the heated cooling fluid from the server system 100 and returns it to the fluid cooler device 2, where the cooling fluid is cooled again before being recirculated into the inner supply conduit 4 of the power cable 3.

In an embodiment, the server system 100 also comprise a circuit 101 for circulating the cooling fluid coming from the power cable inner supply conduit 4 and going back to the fluid cooler device 2. The circuit 101 may comprise a pump.

It is to be noted that the return conduit 5 is physically distinct and separated from the power cable 3, thus from the inner supply conduit 4, too. In this manner, the heated cooling fluid coming from the server system 100 does not transfer heat to the cold cooling fluid in the power cable inner supply conduit 4 and to the conductor thereof.

The power cable 3 can be connected to the server system 100 through a connector 6. In an embodiment, the connector 6 is shaped to connect the power cable 3 to the server system 100 both electrically (to deliver electric power) and fluidically (to the deliver the cooling fluid), as depicted in the example of Figure 1. In another embodiment, the connector 6 is shaped to connect the power cable 3 to the server system 100 only electrically. In this case, the power cable inner supply conduit 4 exits the power cable 3, e.g., near the connector 6, and joins the server system circuit 101 at a circuit entrance 102 distinct from the electrical connection with the connector 6, as depicted in the example of Figure 2.

Similarly, in other embodiments not shown in the Figures, the power cable 3 inner supply conduit 4 can enter the power cable 3 separately from the connection point of the power cable 3 with the power source 200.

Figure 3 depicts an embodiment of a single power cable 3. The power cable 3 comprises the, e.g., centrally positioned, inner supply conduit 4 defining a central internal passage 31 for carrying the cooling fluid. The inner supply conduit 4 can be made of a polymeric material.

The power cable 3 comprises an electrical conductor 32, e.g. arranged in a radially external position with respect to the inner supply conduit 4. The electrical conductor 32 can include a plurality of metallic wires or of groups of wires, wherein the individual wires or the wire groups are stranded on and around the inner supply conduit 4. In an embodiment, the plurality of metallic wires or wire groups are helically wound around the inner supply conduit 4.

In an embodiment (not shown in the Figures), the electrical conductor comprises a plurality of layers of wires placed one on top of the other, wherein each layer of wires has a helical winding of the wires in different directions.

In another embodiment (not shown in the Figures), the electrical conductor is arranged within the internal passage and extend longitudinally along the inner supply conduit. The electrical conductor can include a group of stranded wires wound about a central longitudinal direction of the power cable. In an alternative form, a group of wires can be stranded about a central thread (not shown). In these embodiments, the cooling fluid is electrically insulating.

The power cable 3 further comprises an electrically insulating layer 33 surrounding the electrical conductor 32.

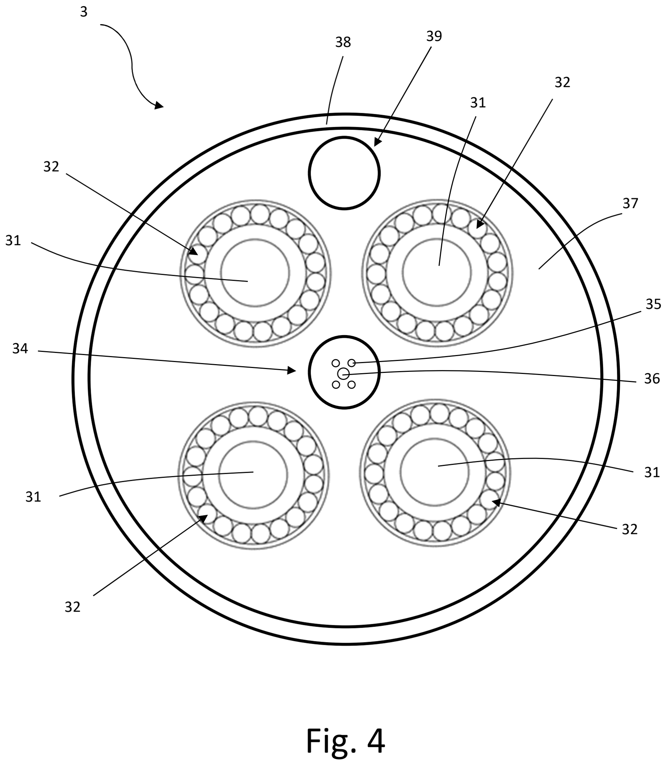

Figure 4 shows a power cable 3 according to another embodiment of the present disclosure. The power cable 3 comprises a plurality of electrical conductors 32 each surrounding a relevant internal passage 31 for the flowing of the cooling fluid as from Figure 3.

In the embodiment illustrated in Fig. 4, the power cable 3 further comprises a data transmission unit 34 extending along the cable central axis. The data transmission unit 34 includes one or more data conductors 35, which can be insulated copper pilot pair and/or optical fibers, for transmission of control signals and/or other data signals. Within the data transmission unit 34, data conductors 35 can be arranged around a central thread member 36 extending along the cable axis. The data conductors 35 can be embedded in a filling material. The plurality of electrical conductors 32 can be helically wound about the centrally positioned data transmission unit 34.

However, it is to be noted that the data transmission unit 34 may be differently positioned within the power cable 3. For example, the data transmission unit 34 may be placed at any interstitial space between electrical conductors 32.

The power cable 3 can also comprise an earth conductor 39.

A polymeric filler 37 can be extruded around the electrical conductors 32, the data transmission unit 34 and the earth conductor 39. The polymeric filler 37 can be made of an electrically insulating material.

An outer jacket 38, e.g., made of a polymeric material like polyethylene, surrounds the polymeric filler 37. The outer jacket 38, which may be extruded on the polymeric filler 37, forms the exterior of the power cable 3.

The power cable 3 can be a DC power cable or an AC power cable.

## Claims

1. A fluid cooling system (1) for a fluid cooled server system (100), comprising:
- a fluid cooler device (2);
- a power cable (3) configured for providing electric power to the server system (100), the power cable (3) containing at least one inner supply conduit (4) for conveying a cooling fluid from the fluid cooler device (2) to the server system (100); and
- a return conduit (5) for conveying the heated cooling fluid from the server system (100) to the fluid cooler device (2),
wherein the return conduit (5) is physically distinct and separated from the power cable (3).

2. The fluid cooling system (1) of claim 1, wherein the cooling fluid is selected from deionized water, ethylene glycol, a mixture of water and ethylene glycol, an optionally dielectric fluid, engineered fluids.

3. The fluid cooling system (1) of claim 1, further comprising a connector (6) for connecting the power cable (3) to the server system (100) both electrically and fluidically.

4. The fluid cooling system (1) of claim 1, further comprising a connector (6) for connecting the power cable (3) to the server system (100) electrically, wherein the power cable inner supply conduit (4) exits the power cable (3) at a location different from the connector (6).

5. The fluid cooling system (1) of claim 1, wherein the power cable (3) comprises a data transmission unit (34) for providing data to the server system (100).

6. The fluid cooling system (1) of claim 1, wherein each inner supply conduit (4) of said at least one inner supply conduit (4) is radially surrounded by an electrical conductor (32).

7. A server system (100) which is connected to the fluid cooling system (1) of claim 1.

8. The server system (100) of claim 8, wherein the server system (100) and the fluid cooler device (2) are arranged in distinct and thermally insulated locations.
